# EUROPÄISCHE PATENTSCHRIFT

(11) **EP 3 329 288 B1**
(45) Veröffentlichungstag und Bekanntmachung des Hinweises auf die Patenterteilung: **12.12.2018**
(21) Anmeldenummer: 16731043.2
(22) Anmeldetag: 07.06.2016
(51) Int. Cl.: G01R 23/14, G01R 27/28, G01N 21/3581

(54) **VEKTORIELLER NETZWERKANALYSATOR**
VECTOR NETWORK ANALYZER
ANALYSEUR VECTORIEL DE RÉSEAU

(30) Priorität: 28.07.2015 DE 102015214289
(43) Veröffentlichungstag der Anmeldung: 06.06.2018
(73) Patentinhaber: Fraunhofer-Gesellschaft zur Förderung der angewandten Forschung e.V., 80686 München (DE)
(72) Erfinder: VELTHAUS, Karl-Otto, 14532 Kleinmachnow (DE); GÖBEL, Thorsten, 10587 Berlin (DE); CHOI, Jung Han, 10585 Berlin (DE)
(74) Vertreter: Maikowski & Ninnemann Patentanwälte Partnerschaft mbB
(86) Internationale Anmeldenummer: PCT/EP2016/062897
(87) Internationale Veröffentlichungsnummer: WO 2017/017579

(56) Entgegenhaltungen:
- DE-A1- 10 246 700
- DE-A1-102010 019 134
- US-B1- 6 348 683
- ZHUANG LEIMENG ET AL: "Photonic High-Bandwidth RF Splitter With Arbitrary Amplitude and Phase Offset", IEEE PHOTONICS TECHNOLOGY LETTERS, IEEE SERVICE CENTER, PISCATAWAY, NJ, US, Bd. 26, Nr. 21, 1. November 2014 (2014-11-01), Seiten 2122-2125, XP011560222, ISSN: 1041-1135, DOI: 10.1109/LPT.2014.2349010 [gefunden am 2014-09-29]

## Beschreibung

Die Erfindung betrifft einen vektoriellen Netzwerkanalysator gemäß Anspruch 1.

Aus dem Stand der Technik sind vektorielle Netzwerkanalysatoren bekannt, mit denen das Reflexions- und/oder Transmissionsverhalten (die "S-Parameter") eines elektronischen Bauelementes oder eines Netzwerkes frequenzabhängig gemessen werden kann.

In der DE 102 46 700 A1 ist ein vektorieller Netzwerkanalysator beschrieben, der über zumindest zwei Tore mit einem Messobjekt verbindbar ist und der mehrere jeweils einem Tor zugeordnete Anregungs-/Empfangseinheiten aufweist. Wenigstens eine Anregungs-/Empfangseinheit hat einen Signalgenerator, mit welchem das Messobjekt mit einem Anregungssignal beaufschlagbar ist. Jede Anregungs-/Empfangseinheit hat zwei Empfangseinrichtungen, mit jeweils einem mit einem Oszillatorsignal in Verbindung stehenden Mischer, der das Anregungssignal oder das von dem zugeordneten Tor reflektierte Signal oder das zu dem zugeordneten Tor transmittierte Signal empfängt und in ein Zwischenfrequenzsignal umsetzt. Jede Anregungs-/Empfangseinheit weist einen eigenen und von dem Signalgenerator getrennten Oszillator auf, der das Oszillatorsignal für die Mischer der Empfangseinrichtungen dieser Anregungs-/Empfangseinheit erzeugt, wobei die Frequenz und/oder Phase des Oszillatorsignals unabhängig von der Frequenz und/oder Phase der Oszillatorsignale der Oszillatoren der anderen Anregungs-/Empfangseinheiten einstellbar ist.

Eine Schwierigkeit besteht in dem Erzeugen und Zuführen eines hochfrequenten elektrischen Signals an das zu vermessende Bauelement, da die elektrischen Verluste etwa von flexiblen Leitungen zu hohen Frequenzen hin überproportional steigen. So werden bei Frequenzen bis 100 GHz verlustreduzierte Leitungen eingesetzt, welche aber nur eine Länge von einigen Dezimetern aufweisen dürfen, um das Messsignal nicht deutlich zu verschlechtern. Zur Erzeugung von Frequenzen oberhalb von 100 GHz werden elektronische Mischerstufen eingesetzt, welche jedoch nur zu sehr hohen Kosten verfügbar sind. Zudem sind derartige Mischerstufen voluminös und führen zu unflexiblen Messaufbauten, da sie mit dem Messobjekt über einen starren Hohlleiter verbunden sein müssen. Des Weiteren kann jede Mischerstufe nur für einen spezifischen Frequenzbereich verwendet werden, wobei für jeden der acht Hohlleiterstandards (WR8 - WR1, von 90 GHz bis 1,1 THz) jeweils eine individuelle, komplexe elektronische Komponente hergestellt werden muss. Eine weitere Möglichkeit zur Durchführung von Hochfrequenzmessungen ist in der US 6,348,683 B1 beschrieben. Dieses Messverfahren erlaubt jedoch u.a. keine Bestimmung der Phasenlage aller transmissiven und reflektierten Messsignale, welche für die Realisierung eines Zweiport-Vektoranalysators notwendig wären.

Das der Erfindung zugrunde liegende Problem besteht darin, einen möglichst kostengünstigen und flexibel handhabbaren Netzwerkanalysator zur Verfügung zu stellen, der eine möglichst umfassende Charakterisierung eines elektronischen Bauelementes insbesondere für Frequenzen bis in den Terahertzbereich ermöglicht.

Dieses Problem wird durch die Bereitstellung des vektoriellen Netzwerkanalysators mit den Merkmalen des Anspruchs 1 gelöst. Weiterbildungen der Erfindung sind in den abhängigen Ansprüchen angegeben.

Danach wird ein vektorieller Netzwerkanalysator bereitgestellt, mit
- einer Eingangsmessvorrichtung, aufweisend:
   - einen Terahertz-Sender zum Beaufschlagen eines Eingangs eines Messobjektes mit einem Terahertz-Signal;
   - einen Terahertz-Empfänger zum Empfangen eines über den Eingang des Messobjektes abgegebenen Terahertz-Signals;
   - einen Terahertz-Referenzempfänger zum Empfangen eines Teils des vom Terahertz-Sender erzeugten Terahertz-Signals;
- einer Ausgangsmessvorichtung, aufweisend:
   - einen Terahertz-Sender zum Beaufschlagen eines Ausgangs des Messobjektes mit einem Terahertz-Signal;
   - einen Terahertz-Empfänger zum Empfangen eines über den Ausgang des Messobjektes abgegebenen Terahertz-Signals;
   - einen Terahertz-Referenzempfänger zum Empfangen eines Teils des vom Terahertz-Sender erzeugten Terahertz-Signals;
- einer Schwebungsquelle zum Erzeugen eines optischen Schwebungssignals;
- einer optischen Übertragungsvorrichtung, die das optische Schwebungssignal in mindestens ein erstes und ein zweites Teilsignal aufteilt, wobei die Übertragungsvorrichtung das erste Teilsignal an zumindest einen der Terahertz-Sender und das zweite Teilsignal an zumindest einen der Terahertz-Empfänger und/oder zumindest einen der Terahertz-Referenzempfänger leitet; und
- einer Phasenveränderungseinheit (ein Phasenbeeinflussungselement) zum Variieren der Phase des ersten und/oder des zweiten Teilsignals des optischen Schwebungssignals.

Bei dem erfindungsgemäßen Netzwerkanalysator handelt es sich somit um einen vollständigen Zwei-Port-Netzwerkanalysator, wobei jeweils an einem Eingang und an einem Ausgang des Messobjektes die Transmission und die Reflexion eines in das Messobjekt eingespeisten Terahertz-Messsignals gemessen werden kann. Darüber hinaus ist es möglich, jeweils ein Referenzsignal des von dem Terahertz-Sender erzeugten Terahertz-Signals zu bestimmen, das insbesondere zur Charakterisierung dieses Terahertz-Signals dient. Mit der Phasenveränderungseinheit lässt sich zudem insbesondere eine Phasenverschiebung zwischen dem ersten und dem zweiten (optischen) Teilsignal einstellen, was insbesondere eine Bestimmung der Phasenlage der von den Terahertz-Empfängern erzeugten Messsignale ermöglicht. Bei den Terahertz-Empfängern handelt es sich insbesondere um kohärente Empfänger, z.B. wie in US 6,348,683 B1. Auf dieses Dokument wird insofern ausdrücklich Bezug genommen.

Gemäß einer Ausgestaltung der Erfindung weist die Eingangsmessvorrichtung und/oder die Ausgangsmessvorichtung einen Wellenleiter mit Richtkopplerwirkung auf, über den das Terahertz-Signal des Terahertz-Senders dem Messobjekt und dem Terahertz-Referenzempfänger, und das vom Messobjekt abgegebene Terahertz-Signal dem Terahertz-Empfänger zuleitbar ist. Bei dem Wellenleiter handelt es sich insbesondere um einen Hohlwellenleiter. Diese Variante der Erfindung ist jedoch nicht auf Wellenleiter in Form von Hohlwellenleitern beschränkt, sondern es sind im Prinzip beliebige wellenleitende Strukturen verwendbar; beispielsweise auch photonische Kristalle. Der Wellenleiter erstreckt sich z.B. zumindest abschnittsweise geradlinig und kann einen im Prinzip beliebigen Querschnitt aufweisen, zum Beispiel einen kreisförmigen oder rechteckigen (insbesondere quadratischen) Querschnitt. Darüber hinaus weist der Wellenleiter einen Eingang (insbesondere in Form einer in einer ersten Stirnseite des Wellenleiters ausgeformten Öffnung) und einen Ausgang (insbesondere in Form einer in einer von der ersten Stirnseite abgewandten zweiten Stirnseite des Wellenleiters ausgeformten Öffnung) auf, wobei der Terahertz-Sender insbesondere an und/oder in dem Eingang angeordnet ist. Denkbar ist auch, dass mehr als eine Eingangsmessvorrichtung und/oder mehr als eine Ausgangsmessvorichtung vorhanden sind.

Bei dem Terahertz-Sender handelt es sich beispielsweise um eine Vorrichtung, die einen mit einer Antenne gekoppelten/integrierten. Fotomixer umfasst. Der Fotomixer wiederum besteht entweder aus einem optischen Fotoleiter oder einer optische Fotodiode. Insbesondere wird unter einem Terahertz-Sender bzw. einem Terahertz-Empfänger ein Sender bzw. Empfänger verstanden, der elektromagnetische Strahlung mit Frequenzen bis in den Terahertz-Bereich hinein erzeugt, insbesondere wird der Bereich zwischen 90 GHz bis 3 THz abgedeckt.

Der Aufbau des Terahertz-Empfängers kann dem Aufbau des Terahertz-Senders entsprechen, wobei jedoch der Fotomixer und/oder die Antenne ein abweichendes Design besitzen können (beispielsweise weist der Terahertz-Empfänger keine Fotodiode, sondern einen Fotoleiter auf). Der Terahertz-Sender und die Terahertz-Empfänger können in kompakter Bauweise realisiert werden, so dass die opto-elektronischen "Tastköpfe" des erfindungsgemäßen Netzwerkanalysators, d.h. insbesondere die Hohlwellenleiter mit den ihnen jeweils zugeordneten Terahertz-Sendern und Terahertz-Empfängern, ebenfalls eine insbesondere im Vergleich mit den Tastköpfen der vorbekannten rein elektrischen Netzwerkanalysatoren kompakte Bauform besitzen können. Beispielsweise können durch den erfindungsgemäßen Ansatz teure und unhandlich große elektrische Mischerstufen durch kleinere Tastköpfe (mit kompakteren opto-elektrischen Sendern und Empfängern) ersetzt werden. Diese opto-elektrischen Sender und Empfänger werden z.B. für jeden Hohlleiterstandard (W8-W1), nach dem die Hohlwellenleiter ausgelegt sein können, individuell realisiert. Die optische Schwebungsquelle (z.B. mindestens ein als Lichtquelle eingesetzter Laser der optischen Schwebungsquelle) sowie die Phasenveränderungseinheit können jedoch für alle Frequenzen (z.B. auch bis oberhalb von 1 THz) unverändert bleiben. Hierdurch kann ein kleines und damit flexibles Messsystem realisiert werden, welches insbesondere deutlich günstiger herstellbar sein kann als konventionelle, rein elektrische Messsysteme (z.B. um den Faktor 10 günstiger).

Die optische Übertragungsvorrichtung des erfindungsgemäßen Netzwerkanalysators umfasst beispielsweise mindestens einen ersten optischen Wellenleiter (zum Beispiel in Form einer Glasfaser), über den das erste optische Teilsignal an zumindest einen der Terahertz-Sender leitbar ist, und mindestens einen zweiten optischen Wellenleiter, über den das zweite optische Teilsignal an zumindest einen der Terahertz-Empfänger und/oder zumindest einen der Terahertz-Referenzempfänger leitbar ist. Der erste und/oder der zweite optische Wellenleiter sind insbesondere mit dem jeweiligen Fotomixer des Terahertz-Senders, der Terahertz-Empfänger bzw. der Terahertz-Referenzempfänger gekoppelt, zum Beispiel jeweils über eine Abbildungsoptik (etwa in Form einer Linse).

Möglich ist auch, dass der erfindungsgemäße vektorielle Netzwerkanalysator einen mit dem (z.B. als Hohlwellenleiter ausgebildeten) Wellenleiter gekoppelten weiteren Wellenleiter (z.B. in Form eines weiteren Hohlwellenleiters) aufweist, wobei mindestens ein Übergang (insbesondere ein Durchgang) vorhanden ist, über den ein Terahertz-Signal aus dem Wellenleiter in den weiteren Wellenleiter überkoppeln kann. Beispielsweise ist ein erster und ein zweiter Übergang vorhanden, über die ein Terahertz-Signal aus dem Wellenleiter in den weiteren Wellenleiter überkoppeln und zu dem Terahertz-Empfänger und dem Terahertz-Referenzempfänger gelangen kann. Insbesondere bei Verwendung zweiter Hohlwellenleiter als erster und zweiter Wellenleiter werden der erste und der zweite Übergang jeweils insbesondere durch miteinander fluchtende Öffnungen in Seitenwänden des Hohlwellenleiters und des weiteren Hohlwellenleiter ausgebildet. Beispielsweise befinden sich die Öffnungen jeweils in Seitenabschnitten des Hohlwellenleiters und des weiteren Hohlwellenleiters, die zumindest näherungsweise parallel (und insbesondere geradlinig) zueinander verlaufen.

Um einen möglichst breiten Frequenzbereich der Terahertz-Signale aus dem Wellenleiter in den weiteren Wellenleiter überkoppeln zu können, ist es auch möglich, dass mehr als zwei Übergänge vorgesehen sind. Über den Durchmesser und/oder den Abstand der Übergänge voneinander lässt sich zudem der Koppelfaktor in Bezug auf das Überkoppeln der Terahertz-Wellen aus dem Wellenleiter in den weiteren Wellenleiter festlegen.

Gemäß einer anderen Ausgestaltung der Erfindung weist der weitere Wellenleiter einen ersten Ausgang auf, über den ein Terahertz-Signal (z.B. das in den weiteren Hohlwellenleiter übergekoppelte, vom Messobjekt abgegebene Terahertz-Signal) dem Terahertz-Empfänger zuleitbar ist. Der Ausgang ist insbesondere in Form einer Öffnung in einer dem Terahertz-Empfänger zugewandten Stirnseite des weiteren Wellenleiter ausgebildet. Möglich ist auch, dass der weitere Wellenleiter einen zweiten Ausgang aufweist, über den ein Terahertz-Signal (z.B. das in den weiteren Wellenleiter übergekoppelte Terahertz-Signal des Terahertz-Senders) dem Terahertz-Referenzempfänger zuleitbar ist. Der zweite Ausgang ist analog zum ersten Ausgang ebenfalls insbesondere in Form einer Öffnung (in einer weiteren Stirnseite) des Wellenleiter ausgeformt. Denkbar ist, dass der weitere Wellenleiter einen geradlinig verlaufenden Abschnitt aufweist, der parallel zu zumindest einem Abschnitt des Wellenleiters verläuft. Darüber hinaus kann der weitere Wellenleiter Endabschnitte besitzen, die sich unter einem Winkel zu dem geradlinig verlaufenden Abschnitt erstrecken. Beispielsweise ist der weitere Wellenleiter (in seitlicher Draufsicht) zumindest näherungsweise U- oder V-artig ausgebildet.

Möglich ist darüber hinaus, dass mit dem Wellenleiter eine (z.B. flexible) Hochfrequenzleitung (etwa eine Koaxial- oder Koplanarleitung) gekoppelt ist, über die aus dem Wellenleiter austretende Terahertz-Strahlung dem Messobjekt zugeleitet wird. Beispielsweise ist ein Konverter vorgesehen, über den der Wellenleiter, d.h. der messobjektseitige Ausgang des Wellenleiters, mit der Hochfrequenzleitung verbunden ist. Denkbar ist auch, dass ein durchgehender Wellenleiter (z.B. ein durchgehender Hohlwellenleiter verwendet wird), der das Signal von dem Terahertz-Sender bis zum dem Messobjekt leitet.

Gemäß einer anderen Weiterbildung weist der erfindungsgemäße Netzwerkanalysator ein abbildendes Element auf, über das das Terahertz-Signal des Terahertz-Senders in den Wellenleiter einkoppelbar ist. Das abbildende Element ist insbesondere aus einem dielektrischen Material oder einem Metamaterial ausgebildet, wobei es sich zum Beispiel um eine Linse handelt, die etwa planar oder zumindest teilweise sphärisch ausgebildet ist.

Darüber hinaus kann jeweils ein abbildendes Element, z.B. ebenfalls eine (etwa wie oben erwähnt ausgebildete) Linse, vorhanden sein, über die Terahertz-Wellen aus dem weiteren Wellenleiter ausgekoppelt werden. Denkbar ist, dass den Ausgängen des weiteren Wellenleiters jeweils ein derartiges abbildendes Element zugeordnet ist, mit dem jeweils insbesondere die sich im weiteren Wellenleiter ausbreitenden Terahertz-Wellen auf den Fotomixer des Terahertz-Empfängers bzw. auf den Fotomixer des Terahertz-Referenzempfängers abgebildet werden.

Nach einem anderen Ausführungsbeispiel des erfindungsgemäßen Netzwerkanalysators weist dessen Phasenveränderungseinheit eine mechanisch verstellbare optische Verzögerungsstrecke auf. Beispielsweise umfasst die Verzögerungsstrecke zwei unter einem Winkel zueinander angeordnete Umlenkelemente, die gemeinsam linear bewegbar sind. Derartige mechanische Verzögerungsstrecken sind jedoch an sich bekannt, so dass hierauf nicht weiter eingegangen wird.

Denkbar ist auch, dass die Phasenveränderungseinheit einen Phasenmodulator umfasst. Beispielsweise handelt es sich um einen polarisationsselektiven Phasenmodulator, der unterschiedlich polarisierte Komponenten des Schwebungssignals unterschiedlich beeinflusst. Beispielsweise wird nur eine der Komponenten des optischen Schwebungssignals phasenverschoben. Auf diese Weise lässt sich ohne mechanische Verzögerungsstrecke eine Phasenverschiebung zwischen dem ersten und dem zweiten Teilsignal des optischen Schwebungssignals erzeugen. Dieses Verfahren ist insbesondere in dem Patent EP 2 488 917 B1 beschrieben, auf das insofern hiermit ausdrücklich Bezug genommen wird.

Die optische Schwebungsquelle weist zum Beispiel zwei Laser mit geringfügig unterschiedlicher Emissionswellenlänge auf. Die emittierte Strahlung der beiden Laser wird überlagert, wodurch das optische Schwebungssignal entsteht. Denkbar ist, dass zur Überlagerung der von den Lasern erzeugten Strahlung ein optischer Koppler verwendet wird. Beispielsweise wird die von den Lasern jeweils emittierte Strahlung über eine Glasfaser in den Koppler geleitet. Der Koppler kann darüber hinaus gleichzeitig zum Aufteilen des durch das Überlagern der Laserstrahlung erzeugten Schwebungssignals in das erste und das zweite Teilsignal dienen. Beispielsweise weist der Koppler zwei Ausgänge auf, über die das erste bzw. das zweite Teilsignal an mindestens einen der Terahertz-Sender bzw. an mindestens einen der Terahertz-Empfänger und/oder an mindestens einen der Terahertz-Referenzempfänger geleitet wird.

Denkbar ist darüber hinaus, dass die Phasenveränderungseinheit (zum Beispiel in Form des oben bereits erwähnten Phasenmodulators) in einer der vom Koppler wegführenden Übertragungsstrecke vorgesehen ist. Die wegführende Übertragungsstrecke ist z.B. durch mindestens eine Glasfaser realisiert.

Gemäß einer anderen Ausgestaltung der Erfindung weist die Schwebungsquelle einen Zweimodenlaser auf, der gleichzeitig zwei Moden geringfügig unterschiedlicher Wellenlänge erzeugt, wobei sich die Moden bereits im Laser überlagern und der Laser somit unmittelbar das optische Schwebungssignal abgibt. Das Aufteilen dieses Schwebungssignals in das erste und das zweite Teilsignal kann dann zum Beispiel über einen entsprechenden Splitter erfolgen.

Die Erfindung wird im Folgenden anhand von Ausführungsbeispielen unter Bezugnahme auf die Figuren näher erläutert. Es zeigen:
- Figur 1: eine schematische Darstellung eines erfindungsgemäßen Netzwerkanalysators;
- Figur 2: eine Variante des Netzwerkanalysators aus Figur 1;
- Figur 3: eine weitere Variante des Netzwerkanalysators aus Figur 1;
- Figur 4: eine schematische Darstellung eines Teiles eines erfindungsgemäßen Netzwerkanalysators;
- Figur 5: eine schematische Darstellung einer Hohlleiteranordnung des erfindungsgemäßen Netzwerkanalysators;
- Figur 6: ein Detail der Hohlleiteranordnung aus Figur 5;
- Figur 7: ein weiteres Detail der Hohlleiteranordnung aus Figur 5;
- Figur 8: ein weiteres Detail der Hohlleiteranordnung aus Figur 5;
- Figur 9: eine perspektivische Ansicht eines Terahertz-Senders eines erfindungsgemäßen Netzwerkanalysators.

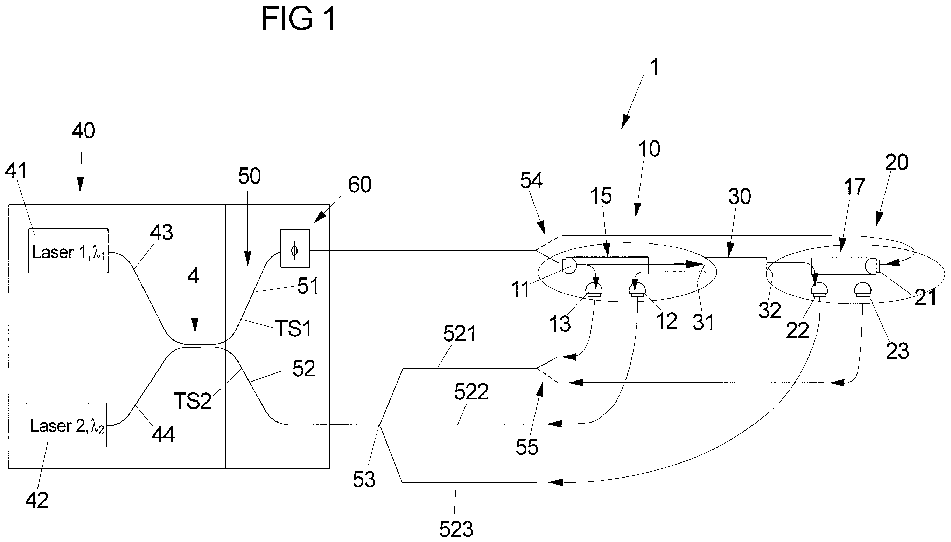

Der in Figur 1 dargestellte erfindungsgemäße Netzwerkanalysator 1 umfasst eine Eingangsmessvorrichtung 10 sowie eine Ausgangsmessvorichtung 20. Die Eingangs- und die Ausgangsmessvorichtung 10, 20 weisen jeweils einen Terahertz-Sender 11 bzw. 21 auf, wobei der Terahertz-Sender 11 der Eingangsmessvorrichtung 10 zum Beaufschlagen eines Einganges 31 eines Messobjektes 30 ("DUT") und der Terahertz-Sender 21 der Ausgangsmessvorrichtung 20 zum Beaufschlagen eines Ausgangs 32 des Messobjektes 30 dienen.

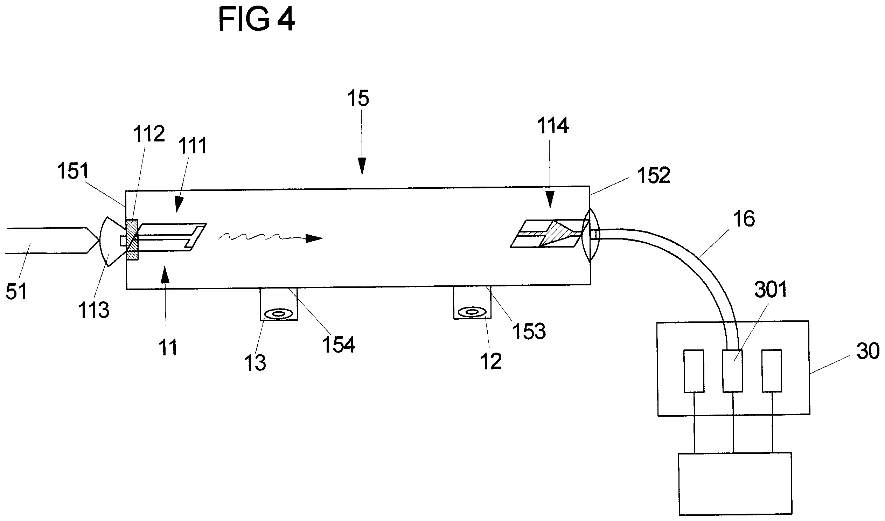

Das von den Terahertz-Sendern 11, 21 ausgesandte Terahertz-Signal wird jeweils über einen Wellenleiter in Form eines (insbesondere starren) Hohlwellenleiters 15, 17 an das Messobjekt 30 übertragen, wobei die Terahertz-Sender 11, 21 jeweils an und/oder in einem Ausgang des jeweiligen Hohlwellenleiters 15, 17 angeordnet sind. Ein Beispiel für die Anordnung der Terahertz-Sender 11, 21 an den Hohlwellenleitern 15, 17 wird weiter unten anhand der Figur 4 erläutert. Es wurde bereits oben darauf hingewiesen, dass die Erfindung natürlich nicht auf die Verwendung eines Hohlwellenleiters zur Führung der Terahertz-Signale beschränkt ist. Vielmehr können im Prinzip beliebige Typen von richtkoppelnden Wellenleitern verwendet werden.

Die Eingangs- und die Ausgangsmessvorichtung 10, 20 weisen des Weiteren jeweils einen Terahertz-Empfänger 12 bzw. 22 auf. Der Terahertz-Empfänger 12 der Eingangsmessvorrichtung 10 dient zum Empfangen eines über den Eingang 31 des Messobjektes 30 abgegebenen Terahertz-Signals, zum Beispiel eines von dem Messobjekt 30 reflektierten oder durch das Messobjekt 30 hindurch transmittierten Signals. Analog ist der Terahertz-Empfänger 12 der Ausgangsmessvorichtung 20 zum Empfang eines über den Ausgang 32 des Messobjektes 30 abgegebenen Terahertz-Signals vorgesehen.

Die Eingangs- und die Ausgangsmessvorichtung 10, 20 weisen zudem jeweils einen Terahertz-Referenzempfänger 13 bzw. 23 auf, mit denen jeweils ein Teil der von den jeweiligen Terahertz-Sender 11, 21 erzeugten Terahertz-Strahlung empfangen werden kann. Die Referenzempfänger 13, 23 dienen somit insbesondere zur Charakterisierung der von den Terahertz-Sendern 11, 21 abgegebenen Terahertz-Strahlung. Es wird darauf hingewiesen, dass die Positionen des Terahertz-Empfängers 12, 22 und des Terahertz-Referenzempfängers 13, 23 auch vertauscht sein können, so dass der Terahertz-Empfänger 12, 22 jeweils auch näher an dem Terahertz-Sender 11, 21 liegen kann als der Terahertz-Referenzempfänger 13, 23. Denkbar ist natürlich auch, dass die Terahertz-Empfänger 12, 22 und die Terahertz-Referenzempfängers 13, 23 zumindest näherungsweise den gleichen Abstand von dem jeweiligen Terahertz-Sender 11, 21 haben.

Der vektorielle Netzwerkanalysator 1 umfasst darüber hinaus eine optische Schwebungsquelle 40, mit der ein optisches Schwebungssignal erzeugt werden kann. Im Ausführungsbeispiel der Figur 1 umfasst die Schwebungsquelle 40 einen ersten und zweiten Laser 41, 42, die geringfügig gegeneinander verstimmt sind, d.h. geringfügig andere Emissionswellenlängen λ1, λ2 besitzen. Die von den Lasern 41, 42 erzeugte Strahlung wird in einem Koppler 4 überlagert, wodurch das gewünschte optische Schwebungssignal entsteht. Das von den Lasern 41, 42 erzeugte Licht wird über Glasfasern 43, 44 in den Koppler 4 eingeleitet.

Der Koppler 4 ist zudem Bestandteil einer optischen Übertragungsvorrichtung 50 des Netzwerkanalysators 1, die das optische Schwebungssignal in ein erstes und ein zweites Teilsignal TS1, TS2 aufteilt. Das erste optische Teilsignal TS1 ist über eine mit dem Koppler 4 verbundene Glasfaser 51 dem Terahertz-Sender 11 der Eingangsmessvorrichtung 10 und/oder dem Terahertz-Sender 21 der Ausgangsmessvorichtung 20 zuleitbar. Die Übertragungsvorrichtung 50 umfasst des Weiteren einen optischen Schalter 54, über den das über die Glasfaser 51 geführte Licht (d.h. das erste Teilsignal TS1) entweder dem Terahertz-Sender 11 der Eingangsmessvorrichtung 10 oder dem Terahertz-Sender 21 der Ausgangsmessvorichtung 20 zugeführt wird.

Des Weiteren umfasst die optische Übertragungsvorrichtung 50 eine weitere Glasfaser 52, mit der das zweite Teilsignal TS2 den kohärenten Terahertz-Empfängern 12, 23 sowie den kohärenten Referenzempfängern 13, 23 der Eingangs- bzw. der Ausgangsmessvorichtung 10, 20 zuleitbar ist. Insbesondere wird das über die Glasfaser 52 von dem Koppler 4 weggeführte zweite Teilsignal TS2 über einen Splitter 53 auf weitere Glasfaserverbindungen 521 - 523 aufgeteilt. Die Glasfaserverbindungen 522 und 523 leiten das zweite Teilsignal TS2 zu den Terahertz-Empfängern 12, 23, während über die Glasfaserverbindung 521 das zweite Teilsignal TS2 entweder dem Referenzempfänger 13 der Eingangsmessvorrichtung 10 oder dem Referenzempfänger 23 der Ausgangsmessvorichtung 20 zugeführt wird. Möglich ist, dass ein weiterer optischer Schalter 55 vorgesehen ist, über den entweder der Referenzempfänger 13 oder der Referenzempfänger 23 mit demjenigen Ausgang des Kopplers 4 verbunden ist (über den Splitter 53), der das zweite Teilsignal TS2 aussendet.

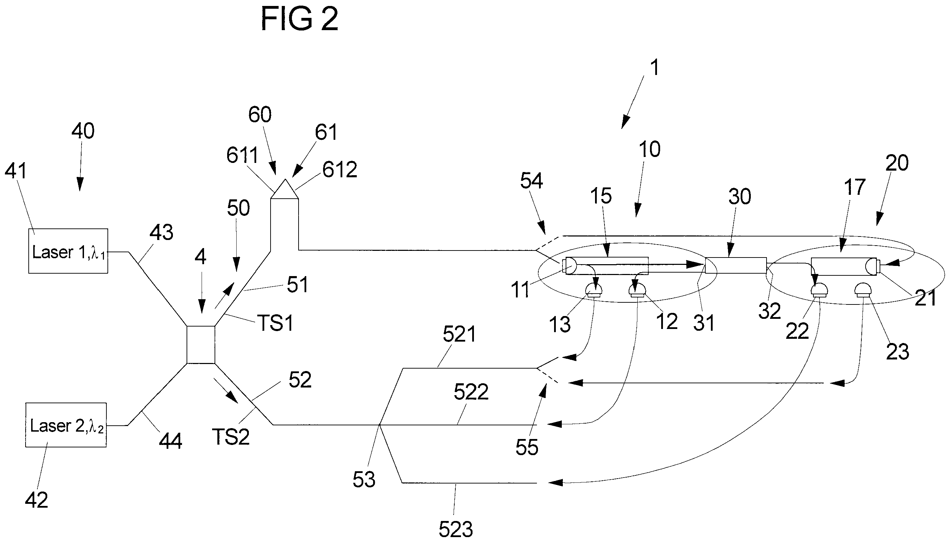

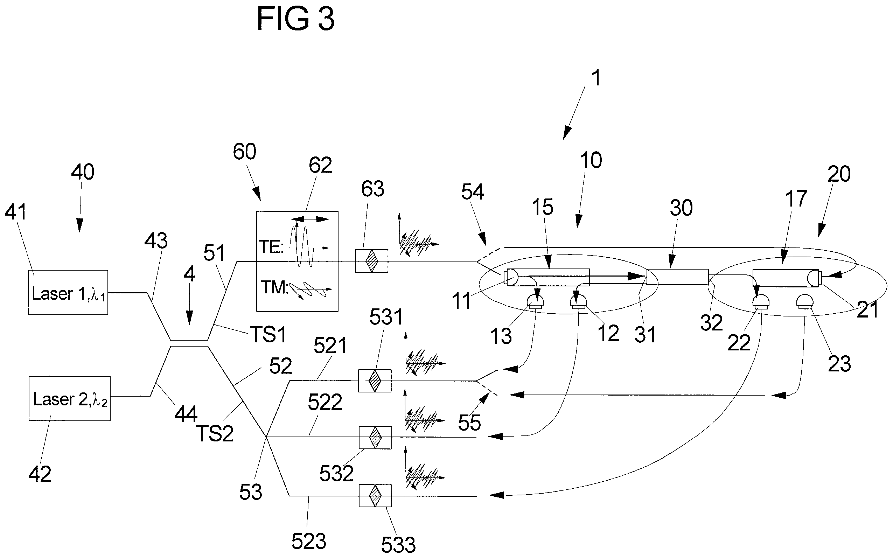

Der erfindungsgemäße Netzwerkanalysator 1 umfasst des Weiteren eine Phasenveränderungseinheit 60, mit der die Phase des ersten Teilsignals TS1 relativ zu der Phase des zweiten Teilsignals TS2 verändert werden kann. Die Phasenveränderungseinheit 60 ist mit der Glasfaser 51, über die das erste Teilsignal TS1 übertragen wird, gekoppelt. Denkbar ist natürlich auch, dass die Phasenveränderungseinheit 60 so angeordnet wird, dass sie nicht auf das erste Teilsignal TS1, sondern auf das zweite Teilsignal TS2 wirkt. Dies wird insbesondere dadurch realisiert, dass die Phasenveränderungseinheit 60 nicht mit der Glasfaser 51, sondern mit der Glasfaser 52 gekoppelt wird. Mögliche Ausführungen der Phasenveränderungseinheit 60 sind in den Figuren 2 und 3 dargestellt.

Gemäß Figur 2, die im Übrigen der Figur 1 entspricht, umfasst die Phasenveränderungseinheit 60 eine mechanische optische Verzögerungsstrecke 61. Die mechanische Verzögerungsstrecke 61 weist genauer zwei Umlenkelemente 611, 612 auf, die unter einem Winkel gegeneinander orientiert sind. Das über die Glasfaser 51 von dem Koppler 4 weggeleitete erste Teilsignal TS1 wird in die Verzögerungsstrecke 61 per Freistrahl eingekoppelt und in einen Teilabschnitt der Glasfaser 51 eingespeist. Über die Position der Umlenkelemente 611, 612 wird die optische Weglänge, die das erste Teilsignal TS1 zurücklegen muss, und damit die Phase des ersten Teilsignals TS1 relativ zu dem zweiten Teilsignal TS2 eingestellt. Derartige Verzögerungsvorrichtung sind jedoch an sich bekannt.

Figur 3 zeigt eine alternative Ausgestaltung der Phasenveränderungseinheit 60. Hiernach weist die Phasenveränderungseinheit 60 einen polarisationsselektiven Phasenmodulator 62 auf. Der Phasenmodulator 62 ist so beschaffen, dass er nur auf die Phase einer der beiden optischen Komponenten des optischen Schwebungssignals wirkt. Mit anderen Worten wirkt der Phasenmodulator 62 nur auf die von einem der beiden Laser 41, 42 erzeugte (und eine der erwähnten optischen Komponenten des Schwebungssignals bildende) Strahlung. Vorliegend weist die Strahlung des ersten Lasers 41 eine TE-Polarisation und die Strahlung des zweiten Lasers 42 eine TM-Polarisation auf. Der Phasenmodulator 62 ist nun so beschaffen, dass er nur die Phase des TE-polarisierten Lichts, d.h. die Phase der Strahlung des ersten Lasers 41 verändert, während die Phase der in dem optischen Schwebungssignal enthaltenen TM-polarisierten Strahlung des zweiten Laser 42 unverändert bleibt.

In einem nachgeschalteten Polarisator 63 der Phasenveränderungseinheit 60, der hauptsächlich oder ausschließlich Licht einer Polarisation, die unter einem Winkel gegenüber der Polarisation des von den Lasern 41, 42 erzeugten Lichts orientiert ist, transmittiert, werden die beiden Komponenten des optischen Schwebungssignals überlagert, wodurch das gegenüber dem zweiten Teilsignal TS2 phasenverschobene Signal entsteht. Diese Art der Realisierung der Phasenverschiebung ist für sich genommen in dem bereits oben erwähnten europäischen Patent EP 2 488 917 B1 beschrieben.

Das zu den Terahertz-Empfängern 12, 23 und den Terahertz-Referenzempfängern 13, 23 geleitete zweite Teilsignal TS2 (d.h. der jeweils durch den Splitter 53 erzeugte Teil) hiervon) wird ebenfalls durch Polarisatoren 531 - 533 geleitet. Die Polarisatoren 531 - 533 weisen insbesondere ähnliche oder identische Eigenschaften wie der Polarisator 63 auf.

Figur 4 zeigt eine Ausführungsform des Hohlwellenleiters 15 der Eingangsmessvorrichtung 10 in vergrößerter Darstellung. Der Hohlwellenleiter 15 weist einen Ausgang in Form einer in einer Stirnseite des Hohlwellenleiters 15 ausgebildeten Öffnung 151 auf, der der Terahertz-Sender 11 zugeordnet ist. Wie oben bereits erwähnt, weist der Terahertz-Sender 11 eine mit einer Antenne 111 gekoppelte Fotodiode 112 auf. Der Terahertz-Sender 11 befindet sich zumindest zum Teil innerhalb des Hohlwellenleiters 15, wobei der Terahertz-Sender 11 zum Beispiel über die Öffnung 151 in das Innere des Hohlwellenleiters 15 hineinragt. Denkbar ist auch, dass sich der Terahertz-Sender 11 vollständig im Innern des Hohlwellenleiters 15 befindet und lediglich das aus der Glasfaser 51 ausgekoppelte Licht über die Öffnung 151 auf die Fotodiode 112 des Terahertz-Senders 11 gestrahlt wird. Möglich ist natürlich auch, dass der Terahertz-Sender 11 vollständig außerhalb des Hohlwellenleiters 15 angeordnet ist.

Zur Kopplung des aus der Glasfaser 51 austretenden Lichts mit dem Terahertz-Sender 11, d.h. mit dessen Fotodiode 112, kann ein abbildendes Element in Form einer Linse 113 vorgesehen sein. Die von der Antenne 111 des Terahertz-Senders 11 abgestrahlten Terahertz-Wellen breiten sich im Innern des Hohlwellenleiters 15 bis zu seinem hinteren Ausgang (Öffnung 152, die sich in der dem Terahertz-Sender 11 abgewandten Stirnseite des Hohlwellenleiters 15 befindet) aus. Im Bereich der Öffnung 152 des Hohlwellenleiters 15 befindet sich ein Konverter 114, über den das im Hohlleiter 15 geführte Terahertz-Signal in eine Hochfrequenzleitung 16 eingekoppelt werden kann. Diese Hochfrequenzleitung kann je nach gewünschtem Frequenzband unterschiedlich ausgeführt sein. Beispielhaft seien Hohlleiter, Koaxialleiter oder eine Koplanarleitung genannt. Die Hochfrequenzleitung 16 führt das Terahertz-Signal zu dem Messobjekt 30, wobei das Koaxialkabel 16 insbesondere mit mindestens einer Kontaktfläche des Messobjektes 30, zum Beispiel einer Signal-Kontaktfläche 301 einer GSG-Kontaktanordnung, verbunden ist. Die Hochfrequenzleitung 16 bildet zusammen mit dem Hohlwellenleiter 15 gewissermaßen einen Tastkopf des Netzwerkanalysators.

Der Hohlwellenleiter 15 weist darüber hinaus Öffnungen 153, 154 auf, über die ein Teil des im Hohlwellenleiter 15 geführten Terahertz-Signals an den Terahertz-Empfänger 12 bzw. an den Terahertz-Referenzempfänger 13 geleitet wird. Die Ankopplung der Empfänger 12, 13 erfolgt insbesondere analog zur Ankopplung des Terahertz-Senders 11 an den Hohlwellenleiter 15. Die Kopplung des Terahertz-Senders 21 bzw. der Terahertz-Empfänger 22, 23 an den Hohlwellenleiter 17 der Ausgangsmessvorichtung 20 erfolgt insbesondere ähnlich oder identisch zu der Kopplung des Terahertz-Senders 21 bzw. der Terahertz-Empfänger 12, 13 der Eingangsmessvorrichtung 10 an den Hohlwellenleiter 15.

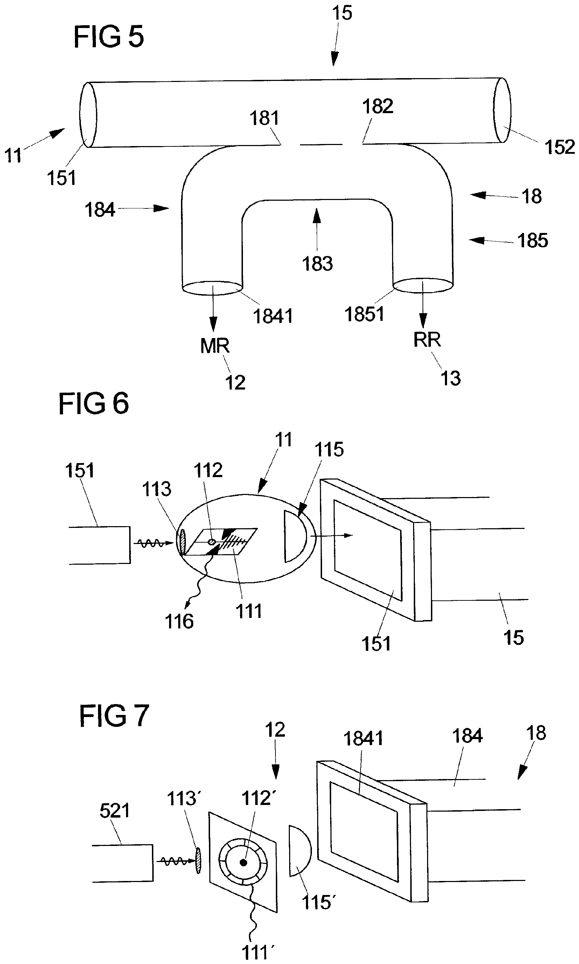

In Figur 5 ist eine weitere Möglichkeit zur Einkopplung eines Terahertz-Signals in den Terahertz-Empfänger (MR) 12 und in den Terahertz-Referenzempfänger (RR) 13 illustriert, wobei die Positionen des Terahertz-Empfängers 12 und des Terahertz-Referenzempfängers 13 gegenüber der Variante der Fig. 1 vertauscht sind. Die Einkopplung in den Terahertz-Empfänger 23 und den Terahertz-Referenzempfänger 22 der Auskoppelmessvorrichtung 20 kann identisch realisiert sein.

Gemäß Fig. 5 ist ein weiterer Wellenleiter in Form eines weiteren Hohlwellenleiters 18 vorhanden, der mit dem Hohlwellenleiter 15 gekoppelt ist. Zur Kopplung der beiden Hohlwellenleiter 15, 18 ist ein erster und ein zweiter Durchgang 181, 182 vorhanden, über den ein Teil eines sich in dem Hohlwellenleiter 15 ausbreitenden Terahertz-Signals in den weiteren Hohlwellenleiter 18 überkoppeln kann. Die Durchgänge 181, 182 sind durch miteinander fluchtende Öffnungen in einander angrenzenden (insbesondere einander anliegenden) Seitenwänden der Hohlwellenleiter 15, 18 ausgebildet. Über den Abstand der Durchgänge (insbesondere ihrer Mitten) 181, 182 lässt sich der Kopplungsfrequenzbereich festlegen. Beispielsweise beträgt der Abstand λ/4 (λ: Wellenlänge der sich im Hohlwellenleiter 15 ausbreitenden Terahertz-Wellen). Denkbar ist auch, dass mehr als zwei Durchgänge vorgesehen sind, insbesondere, um den Frequenzbereich der überkoppelnden Wellen zu vergrößern. Darüber hinaus könnte anstelle der Hohlwellenleiter 15, 18 eine andere (nicht als Hohlwellenleiter ausgebildete) richtkoppelnde Struktur (oder mehrere richtkoppelnde Strukturen) verwendet werden, wie bereits oben erläutert.

Der weitere Hohlwellenleiter 18 weist eine zumindest näherungsweise U-förmige Gestalt auf, wobei von einem sich geradlinig erstreckenden Mittelstück 183 zwei Endabschnitte 184, 185 (zum Beispiel senkrecht) abstehen. Die Endabschnitte 184, 185 besitzen jeweils in ihrer Stirnseite einen Ausgang in Form einer Öffnung 1841, 1851, über die die Empfänger, d.h. der Terahertz-Empfänger 12 und der Terahertz-Referenzempfänger 13, mit dem weiteren Hohlwellenleiter 18 gekoppelt sind. Insbesondere erfolgt die Kopplung der Empfänger 12, 13 analog zur in Zusammenhang mit der Figur 4 beschriebenen Kopplung des Terahertz-Senders 11 mit dem Hohlwellenleiter 15.

Eine Möglichkeit der Einkopplung des aus der Glasfaser 51 austretenden Lichtes mit dem Terahertz-Sender 11 ist in Figur 6 gezeigt (Bereich "P1" in Fig. 5). Danach wird das aus der Glasfaser 51 austretende Licht über die Linse 113 auf den Terahertz-Sender 11 geleitet. Die von der Antenne 111 abgestrahlte Terahertz-Strahlung wird zudem über eine geeignete Linse 115 in den Hohlwellenleiter 15 eingekoppelt. Denkbar ist auch, dass sich die Fotodiode 112 und die Antenne 111 des Terahertz-Senders 11, wie in Figur 4 gezeigt, zumindest teilweise im Innern des Hohlwellenleiters 15 befinden. Entsprechend wäre auch die Linse 115 im Innern des Hohlwellenleiters 15 angeordnet. Denkbar ist auch, dass der Terahertz-Sender 11 einen vor der Antenne 111 angeordneten oder von der Antenne 111 ausgebildeten Reflektor 116 aufweist.

Die Ankopplung der Terahertz-Empfänger 12, 13 kann analog erfolgen, wie in Figur 7 gezeigt. Danach wird das zweite optische Teilsignal TS2 über die Glasfaser 521 an den Terahertz-Empfänger 12 geleitet und über ein abbildendes Element in Form einer Linse 113' auf eine Fotodiode 112' des Terahertz-Empfängers 12 fokussiert. Die aus dem Ausgang 1841 des Endabschnitts 184 des weiteren Hohlwellenleiters 18 austretende Terahertz-Strahlung wird über eine Linse 115' mit einer Antenne 111' (insbesondere in Form einer Breitbandantenne) gekoppelt. Der bei Empfang einer Terahertz-Welle von dem Terahertz-Empfänger 12 erzeugte Strom kann hinsichtlich der Amplitude und Phase der empfangenen Terahertz-Strahlung in an sich bekannter Weise ausgewertet werden.

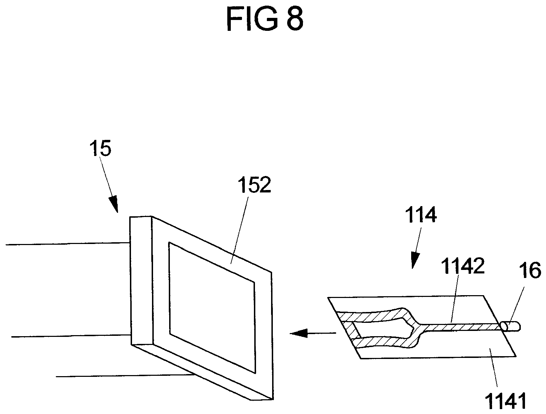

Figur 8 zeigt den an oder in dem hinteren Ende des Hohlwellenleiters 15 angeordneten Konverter 114. Der Konverter 114 weist ein Substrat 1141 auf, auf dem eine Leiterstruktur 1142 aufgebracht ist. Die Leiterstruktur 1142 verjüngt sich von der Ausgangsöffnung 152 des Hohlwellenleiters 15 zum Koaxialkabel 16 hin. Insbesondere weist die Leiterstruktur 1142 auf seiner dem Hohlwellenleiter 15 zugewandten Seite zwei (oder mehr) voneinander beabstandete Leiterabschnitte auf, die sich zu einem einzigen Leiterabschnitt auf der dem Koaxialkabel 16 zugewandten Seite des Konverters 114 vereinigen.

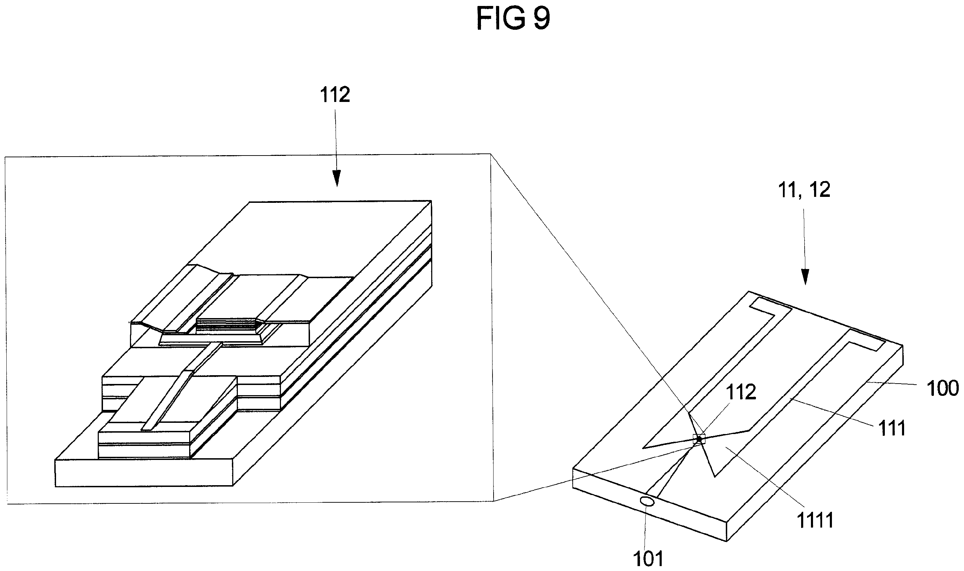

In Figur 9 ist eine mögliche Variante der Terahertz-Sender 11, 21 gezeigt. Danach umfasst der Terahertz-Sender 11, 21 eine Antenne 1111 (etwa in Form einer Bow-Tie-Antenne) sowie eine mit der Antenne 1111 gekoppelte Fotodiode 112 sowie eine mit der Antenne 1111 verbundene Biasversorgung 111. Die Biasversorgung 111, die Bow Tie Antenne 1111 und die Fotodiode 112 befinden sich auf einem gemeinsamen Substrat 100. Denkbar ist, dass in oder an dem Substrat 100 ein Wellenleiter 101 ausgebildet ist, über den Licht der Fotodiode 112 zugeleitet wird. Bei der Fotodiode 112 kann es sich um ein integriert optisches Standard-Bauelement handeln, das z.B. auch in Datenübertragungssystem eingesetzt wird.

## Patentansprüche

1. Vektorieller Netzwerkanalysator, mit
- einer Eingangsmessvorrichtung (10), aufweisend:
- einen Terahertz-Sender (11) zum Beaufschlagen eines Eingangs eines Messobjektes (30) mit einem Terahertz-Signal;
- einen Terahertz-Empfänger (12) zum Empfangen eines über den Eingang des Messobjektes (30) abgegebenen Terahertz-Signals;
- einen Terahertz-Referenzempfänger (13) zum Empfangen eines Teils des vom Terahertz-Sender (11) erzeugten Terahertz-Signals;
- einer Ausgangsmessvorichtung (20), aufweisend:
- einen Terahertz-Sender (21) zum Beaufschlagen eines Ausgangs des Messobjektes (30) mit einem Terahertz-Signal;
- einen Terahertz-Empfänger (22) zum Empfangen eines über den Ausgang des Messobjektes (30) abgegebenen Terahertz-Signals;
- einen Terahertz-Referenzempfänger (23) zum Empfangen eines Teils des vom Terahertz-Sender (21) erzeugten Terahertz-Signals;
- einer Schwebungsquelle (40) zum Erzeugen eines optischen Schwebungssignals;
- einer optischen Übertragungsvorrichtung (50), die das optische Schwebungssignal in mindestens ein erstes und ein zweites Teilsignal (TS1, TS2) aufteilt, wobei die Übertragungsvorrichtung (50) das erste Teilsignal (TS1) an zumindest einen der Terahertz-Sender (11, 21) und das zweite Teilsignal (TS2) an zumindest einen der Terahertz-Empfänger (12, 22) und/oder zumindest einen der Terahertz-Referenzempfänger (13, 23) leitet; und
- einer Phasenveränderungseinheit (60) zum Variieren der Phase des ersten und/oder des zweiten Teilsignals (TS1, TS2) des optischen Schwebungssignals.

2. Vektorieller Netzwerkanalysator nach Anspruch 1, **dadurch gekennzeichnet, dass** die optische Übertragungsvorrichtung (50) mindestens einen ersten optischen Wellenleiter (51), über den das erste Teilsignal (TS1) an zumindest einen der Terahertz-Sender (11, 21) leitbar ist, und mindestens einen zweiten optischen Wellenleiter (52), über den das zweite Teilsignal (TS2) an zumindest einen der Terahertz-Empfänger (12, 22) und/oder zumindest einen der Terahertz-Referenzempfänger (13, 23) leitbar ist, umfasst.

3. Vektorieller Netzwerkanalysator nach Anspruch 1 oder 2, **dadurch gekennzeichnet, dass** die Eingangsmessvorrichtung (10) und/oder die Ausgangsmessvorrichtung (20) einen Wellenleiter (15, 17) aufweist, über den das Terahertz-Signal des Terahertz-Senders (11, 21) dem Messobjekt (30) und dem Terahertz-Referenzempfänger (13, 23), und das vom Messobjekt (30) abgegebene Terahertz-Signal dem Terahertz-Empfänger (12, 22) zuleitbar ist.

4. Vektorieller Netzwerkanalysator nach Anspruch 3, **gekennzeichnet durch** einen mit dem Wellenleiter (15, 17) gekoppelten weiteren Wellenleiter (18), wobei mindestens ein Übergang vorhanden ist, über den ein Terahertz-Signal aus dem Wellenleiter (15, 17) in den weiteren Wellenleiter (18) überkoppeln kann.

5. Vektorieller Netzwerkanalysator nach Anspruch 4, **gekennzeichnet durch** einen ersten und zweiten Übergang (181, 182), über die ein Terahertz-Signal aus dem Wellenleiter (15) in den weiteren Wellenleiter (18) überkoppeln und zu dem Terahertz-Empfänger (12) und dem Terahertz-Referenzempfänger (13) gelangen kann.

6. Vektorieller Netzwerkanalysator nach einem der Ansprüche 3 bis 5, **dadurch gekennzeichnet, dass** der weitere Wellenleiter (18) einen ersten Ausgang (1841) aufweist, über den ein Terahertz-Signal dem Terahertz-Empfänger (12) zuleitbar ist.

7. Vektorieller Netzwerkanalysator nach einem der Ansprüche 3 bis 6, **dadurch gekennzeichnet, dass** der weitere Wellenleiter (18) einen zweiten Ausgang (1851) aufweist, über den ein Terahertz-Signal dem Terahertz-Referenzempfänger (13) zuleitbar ist.

8. Vektorieller Netzwerkanalysator nach einem der Ansprüche 3 bis 7, **gekennzeichnet durch** eine mit dem Wellenleiter (15, 17) gekoppelte Hochfrequenzleitung (16), über die aus dem Wellenleiter (15, 17) austretende Terahertz-Strahlung dem Messobjekt (30) zuleitbar ist.

9. Vektorieller Netzwerkanalysator nach Anspruch 8, **gekennzeichnet durch** einen Konverter (114), über den der Wellenleiter (15) mit der Koaxial- oder Koplanarleitung (16) verbunden ist.

10. Vektorieller Netzwerkanalysator nach einem der Ansprüche 3 bis 9, **gekennzeichnet durch** ein abbildendes Element (115), über das das Terahertz-Signal des Terahertz-Senders (11) in den Wellenleiter (15) einkoppelbar ist.

11. Vektorieller Netzwerkanalysator nach einem der Ansprüche 4 bis 10, **gekennzeichnet durch** ein abbildendes Element (115'), über das ein Terahertz-Signal aus dem weiteren Wellenleiter (18) auskoppelbar ist.

12. Vektorieller Netzwerkanalysator nach einem der vorhergehenden Ansprüche, **dadurch gekennzeichnet, dass** die Phasenveränderungseinheit (60) eine mechanisch verstellbare optische Verzögerungsstrecke (61) umfasst.

13. Vektorieller Netzwerkanalysator nach einem der vorhergehenden Ansprüche, **dadurch gekennzeichnet, dass** die Phasenveränderungseinheit (60) einen Phasenmodulator (62) umfasst.

14. Vektorieller Netzwerkanalysator nach einem der vorhergehenden Ansprüche, **dadurch gekennzeichnet, dass** die Schwebungsquelle (40) zwei Laser (41, 42) mit unterschiedlicher Emissionswellenlänge aufweist.

15. Vektorieller Netzwerkanalysator nach einem der Ansprüche 1 bis 13, **dadurch gekennzeichnet, dass** die Schwebungsquelle (40) einen Zweimodenlaser aufweist.

## Claims

1. Vectorial network analyser comprising
- an input measuring device (10) having:
- a terahertz transmitter (11) for applying a terahertz signal to an input of a measurement object (30);
- a terahertz receiver (12) for receiving a terahertz signal emitted via the input of the measurement object (30);
- a terahertz reference receiver (13) for receiving part of the terahertz signal generated by the terahertz transmitter (11);
- an output measuring device (20) having:
- a terahertz transmitter (21) for applying a terahertz signal to an output of the measurement object (30);
- a terahertz receiver (22) for receiving a terahertz signal emitted via the output of the measurement object (30);
- a terahertz reference receiver (23) for receiving part of the terahertz signal generated by the terahertz transmitter (21);
- a beat source (40) for generating an optical beat signal;
- an optical transfer device (50), which divides the optical beat signal into at least a first and a second partial signal (TS1, TS2), wherein the transfer device (50) guides the first partial signal (TS1) to at least one of the terahertz transmitters (11, 21) and the second partial signal (TS2) to at least one of the terahertz receivers (12, 22) and/or at least one of the terahertz reference receivers (13, 23); and
- a phase changing unit (60) for varying the phase of the first and/or the second partial signal (TS1, TS2) of the optical beat signal.

2. Vectorial network analyser according to Claim 1, **characterized in that** the optical transfer device (50) comprises at least one first optical waveguide (51), via which the first partial signal (TS1) is guidable to at least one of the terahertz transmitters (11, 21), and at least one second optical waveguide (52), via which the second partial signal (TS2) is guidable to at least one of the terahertz receivers (12, 22) and/or at least one of the terahertz reference receivers (13, 23).

3. Vectorial network analyser according to Claim 1 or 2, **characterized in that** the input measuring device (10) and/or the output measuring device (20) have/has a waveguide (15, 17), via which the terahertz signal of the terahertz transmitter (11, 21) is feedable to the measurement object (30) and to the terahertz reference receiver (13, 23) and the terahertz signal emitted by the measurement object (30) is feedable to the terahertz receiver (12, 22).

4. Vectorial network analyser according to Claim 3, **characterized by** a further waveguide (18), which is coupled to the waveguide (15, 17), wherein at least one junction is present via which a terahertz signal can couple over from the waveguide (15, 17) into the further waveguide (18) .

5. Vectorial network analyser according to Claim 4, **characterized by** a first and second junction (181, 182), via which a terahertz signal can couple over from the waveguide (15) into the further waveguide (18) and pass to the terahertz receiver (12) and the terahertz reference receiver (13).

6. Vectorial network analyser according to any of Claims 3 to 5, **characterized in that** the further waveguide (18) has a first output (1841), via which a terahertz signal is feedable to the terahertz receiver (12).

7. Vectorial network analyser according to any of Claims 3 to 6, **characterized in that** the further waveguide (18) has a second output (1851), via which a terahertz signal is feedable to the terahertz reference receiver (13).

8. Vectorial network analyser according to any of Claims 3 to 7, **characterized by** a high-frequency line (16) coupled to the waveguide (15, 17), via which radio-frequency line the terahertz radiation emerging from the waveguide (15, 17) is feedable to the measurement object (30).

9. Vectorial network analyser according to Claim 8, **characterized by** a converter (114), via which the waveguide (15) is connected to the coaxial or coplanar line (16).

10. Vectorial network analyser according to any of Claims 3 to 9, **characterized by** an imaging element (115), via which the terahertz signal of the terahertz transmitter (11) is able to be coupled into the waveguide (15).

11. Vectorial network analyser according to any of Claims 4 to 10, **characterized by** an imaging element (115'), via which a terahertz signal is able to be coupled out of the further waveguide (18) .

12. Vectorial network analyser according to any of the preceding claims, **characterized in that** the phase changing unit (60) comprises a mechanically adjustable optical delay section (61).

13. Vectorial network analyser according to any of the preceding claims, **characterized in that** the phase changing unit (60) comprises a phase modulator (62) .

14. Vectorial network analyser according to any of the preceding claims, **characterized in that** the beat source (40) has two lasers (41, 42) having a different emission wavelength.

15. Vectorial network analyser according to any of Claims 1 to 13, **characterized in that** the beat source (40) has a dual-mode laser.

## Revendications

1. Analyseur vectoriel de réseau, comportant
- un dispositif de mesure d'entrée (10), présentant :
-- un émetteur térahertz (11) pour fournir un signal térahertz à une entrée d'un objet de mesure (30) ;
-- un récepteur térahertz (12) pour recevoir un signal térahertz délivré par l'entrée de l'objet de mesure (30);
-- un récepteur de référence térahertz (13) pour recevoir une partie du signal térahertz produit par l'émetteur térahertz (11) ;
- un dispositif de mesure de sortie (20), présentant :
-- un émetteur térahertz (21) pour fournir un signal térahertz à une sortie de l'objet de mesure (30) ;
-- un récepteur térahertz (22) pour recevoir un signal térahertz délivré par la sortie de l'objet de mesure (30);
-- un récepteur de référence térahertz (23) pour recevoir une partie du signal térahertz produit par l'émetteur térahertz (21) ;
- une source de battement (40) pour produire un signal de battement optique ;
- un dispositif de transmission optique (50) qui divise le signal de battement optique en au moins un premier et un deuxième signal partiel (TS1, TS2), dans lequel le dispositif de transmission (50) guide le premier signal partiel (TS1) vers au moins l'un des émetteurs térahertz (11, 21) et le deuxième signal partiel (TS2) vers au moins l'un des récepteurs térahertz (12, 22) et/ou au moins l'un des récepteurs de référence térahertz (13, 23) ; et
- une unité de modification de phase (60) pour faire varier la phase du premier et/ou du deuxième signal partiel (TS1, TS2) du signal de battement optique.

2. Analyseur vectoriel de réseau selon la revendication 1, **caractérisé en ce que** le dispositif de transmission optique (50) comprend au moins un premier guide d'ondes optique (51) par lequel le premier signal partiel (TS1) peut être guidé vers au moins l'un des émetteurs térahertz (11, 21), et au moins un deuxième guide d'ondes optique (52) par lequel le deuxième signal partiel (TS2) peut être guidé vers au moins l'un des récepteurs térahertz (12, 22) et/ou au moins l'un des récepteurs de référence térahertz (13, 23).

3. Analyseur vectoriel de réseau selon la revendication 1 ou 2, **caractérisé en ce que** le dispositif de mesure d'entrée (10) et/ou le dispositif de mesure de sortie (20) présente un guide d'ondes (15, 17) par lequel le signal térahertz de l'émetteur térahertz (11, 21) peut être acheminé à l'objet de mesure (30) et au récepteur de référence térahertz (13, 23), et le signal térahertz délivré par l'objet de mesure (30) peut être acheminé au récepteur térahertz (12, 22).

4. Analyseur vectoriel de réseau selon la revendication 3, **caractérisé par** un autre guide d'ondes (18) couplé au guide d'ondes (15, 17), dans lequel il existe au moins un passage par lequel un signal térahertz issu du guide d'ondes (15, 17) peut être surcouplé dans l'autre guide d'ondes (18).

5. Analyseur vectoriel de réseau selon la revendication 4, **caractérisé par** un premier et un deuxième passage (181, 182), par lesquels un signal térahertz issu du guide d'ondes (15) peut être surcouplé dans l'autre guide d'ondes (18) et peut parvenir au récepteur térahertz (12) et au récepteur de référence térahertz (13).

6. Analyseur vectoriel de réseau selon l'une quelconque des revendications 3 à 5, **caractérisé en ce que** l'autre guide d'ondes (18) présente une première sortie (1841) par laquelle un signal térahertz peut être acheminé au récepteur térahertz (12).

7. Analyseur vectoriel de réseau selon l'une quelconque des revendications 3 à 6, **caractérisé en ce que** l'autre guide d'ondes (18) présente une deuxième sortie (1851) par laquelle un signal térahertz peut être acheminé au récepteur de référence térahertz (13).

8. Analyseur vectoriel de réseau selon l'une quelconque des revendications 3 à 7, **caractérisé par** une ligne à haute fréquence (16) couplée au guide d'ondes (15, 17) par laquelle le rayonnement térahertz sortant du guide d'ondes (15, 17) peut être acheminé à l'objet de mesure (30).

9. Analyseur vectoriel de réseau selon la revendication 8, **caractérisé par** un convertisseur (114) par lequel le guide d'ondes (15) est relié à la ligne coaxiale ou coplanaire (16).

10. Analyseur vectoriel de réseau selon l'une quelconque des revendications 3 à 9, **caractérisé par** un élément d'imagerie (115), par lequel le signal térahertz de l'émetteur térahertz (11) peut être couplé dans le guide d'ondes (15).

11. Analyseur vectoriel de réseau selon l'une quelconque des revendications 4 à 10, **caractérisé par** un élément d'imagerie (115') par lequel un signal térahertz issu de l'autre guide d'ondes (18) peut être découplé.

12. Analyseur vectoriel de réseau selon l'une quelconque des revendications précédentes, **caractérisé en ce que** l'unité de modification de phase (60) comprend une ligne de retard optique (61) pouvant être déplacée mécaniquement.

13. Analyseur vectoriel de réseau selon l'une quelconque des revendications précédentes, **caractérisé en ce que** l'unité de modification de phase (60) comprend un modulateur de phases (62).

14. Analyseur vectoriel de réseau selon l'une quelconque des revendications précédentes, **caractérisé en ce que** la source de battement (40) présente deux lasers (41, 42) ayant des longueurs d'onde d'émission différentes.

15. Analyseur vectoriel de réseau selon l'une quelconque des revendications 1 à 13, **caractérisé en ce que** la source de battement (40) présente un laser bimode.
